# EUROPEAN PATENT SPECIFICATION

(11) **EP 2 770 313 B1**
(45) Date of publication and mention of the grant of the patent: **08.04.2015**
(21) Application number: 13305194.6
(22) Date of filing: 21.02.2013
(51) Int. Cl.: G01K 7/32, G01K 15/00, G05D 23/20

(54) **TEMPERATURE SENSING METHOD GENERATING A TEMPERATURE DEPENDENT AND A TEMPERATURE INDEPENDENT OUTPUT FREQUENCIES**
Temperaturmessverfahren zur Erzeugung von temperaturabhängigen und temperaturunabhängigen Ausgabefrequenzen
Procédé de détection de température générant des fréquences de sortie dépendantes/indépendantes de la température

(43) Date of publication of application: 27.08.2014
(73) Proprietor: ST-Ericsson SA, 1228 Plan-les-Ouates (CH)
(72) Inventor: Cottin, Denis, 38920 CROLLES (FR)
(74) Representative: Hirsch & Associés

(56) References cited:
- AU-B2- 713 261
- DE-A1- 4 200 578
- US-A- 5 255 975
- CHAN-KYUNG KIM ET AL: "CMOS temperature sensor with ring oscillator for mobile DRAM self-refresh control", CIRCUITS AND SYSTEMS, 2008. ISCAS 2008. IEEE INTERNATIONAL SYMPOSIUM ON, IEEE, PISCATAWAY, NJ, USA, 18 May 2008 (2008-05-18), pages 3094-3097, XP031392667, DOI: 10.1109/ISCAS.2008.4542112 ISBN: 978-1-4244-1683-7
- HOKYU LEE ET AL: "A 0.0018 mm2 frequency-to-digital-converter-based CMOS smart temperature sensor", ANALOG INTEGRATED CIRCUITS AND SIGNAL PROCESSING, KLUWER ACADEMIC PUBLISHERS, BO, vol. 64, no. 2, 19 December 2009 (2009-12-19), pages 153-157, XP019812306, ISSN: 1573-1979
- KOSTA LURIA ET AL: "Miniaturized CMOS thermal sensor array for temperature gradient measurement in microprocessors", IEEE INTERNATIONAL SYMPOSIUM ON CIRCUITS AND SYSTEMS. ISCAS 2010 - 30 MAY-2 JUNE 2010 - PARIS, FRANCE, IEEE, US, 30 May 2010 (2010-05-30), pages 1855-1858, XP031725057, ISBN: 978-1-4244-5308-5

## Description

### TECHNICAL FIELD

The invention relates to temperature sensing methods, and more particularly to temperature sensing methods which generate both a temperature dependent output frequency and a temperature independent output frequency.

### BACKGROUND

According to a family of prior art, for example described in an article "CMOS Temperature Sensor with Ring Oscillator for Mobile DRAM Self-refresh Control" by Chan-Kyung Kim; IEEE 2008, P.3094-3097, or in an article "Miniaturized CMOS Thermal Sensor Array for Temperature Gradient Measurement in Microprocessors" by Kosta Luria; IEEE 2010, P.1855-1858, or in an article "A 0.0018 mm2 frequency-to-digital-converter-based CMOS smart temperature sensor" by Hokyu Lee; Analog Integr Circ Sig Process (2010); P.:153-157, a type of digital temperature sensors is known which generates temperature dependent periodic signals, made with temperature dependent current starved ring oscillators or current starved ramp generators. As temperature gradients inside integrated chips can nowadays reach several ten of degrees Celsius, this digital temperature sensor is usually located very close to the hot spots of the integrated circuit. So, for the thermal sensor calibration, insensitive temperature current is commonly used, either to generate a second signal at the output of a matching delay line made by a ramp generator or ring oscillator which is only voltage and process dependent. Calibration solution of this type of digital temperature sensors can therefore be obtained by mixing the two signals which are respectively temperature dependent and temperature independent. AV 713261 B2 discloses such a digital temperature sensor with a temperature dependent oscillator and a temperature independent oscillator wherein calibration is obtained by mixing the two signals. However, this prior art presents several drawbacks.

Firstly, there is a limited precision in the temperature sensing. Indeed, this comes from the bad process correlation existing between temperature independent and temperature dependent currents, leading to a decrease of accuracy, because extra components are introduced, for example the resistor, for generating only one of either the temperature independent current or the temperature dependent current, but not generating the other one.

Secondly, there is a rather important needed area of the integrated circuit, which adds complexity and cost. Indeed, this comes from the need of a second oscillator associated to a second delay line, one oscillator using temperature dependent current and the other oscillator using temperature independent current. So, for the temperature sensor, the required integrated circuit area is multiplied by two.

Thirdly, there is an extra complexity in the design, coming from the need to try and match the different components which are used for these two different oscillators, in order to reduce the existing mismatch. Indeed, the two different oscillators with their two associated delay lines made with logic gates such as inverters will have to be well matched. So, layout constraints happen especially in term of device area and device routing leading either to lower temperature accuracy or to more complexity and cost to correct this temperature accuracy decrease.

All these drawbacks mainly come from the need for two different oscillators in order to be able to generate both a temperature dependent output frequency, for the sensing mode, and a temperature independent output frequency, for the calibration mode.

### SUMMARY

An object of embodiments of the present invention is to alleviate at least partly the above mentioned drawbacks.

More particularly, embodiments of the invention aim to provide a temperature sensing method allowing a calibration mode of the temperature sensor, without need for an extra oscillator dedicated to this calibration mode. Embodiments of the invention aim to provide for a temperature sensing method and a temperature sensor, presenting a sensing mode and a calibration mode, both these modes using the same oscillator to be able to make this same oscillator generate alternatively a temperature dependent signal, for the sensing mode, and a temperature independent signal, for the calibration mode.

Embodiments of the invention preferably aim to create, both and alternatively, a temperature dependent and a temperature independent frequency circuit from the same oscillator circuit, advantageously with a single and simple ramp generator. The switching between those two circuits will provide switching from a temperature independent output frequency, which is used for its calibration by using for example a reference clock usually available on the digital circuits, to a temperature dependent output frequency when the calibration is ended, which is then used for the sensing mode.

In embodiments of the invention, replacing the voltage independent of the temperature (VIOAT) signal by a voltage dependent and preferably proportional to the temperature (VPTAT) signal, without introducing any extra components and without requiring any extra circuit area, allows for the use of a single and same oscillator both in calibration and sensing mode, leading then to better accuracy and to less complexity, for the temperature sensing method and for the associated temperature sensor.

In embodiments of the invention, in a nutshell, there are a temperature dependent, for the normal sensing mode, and a temperature independent, for the calibration mode, signals which are both created by a single oscillator circuit and available at the output of this single oscillator circuit. The switching between those signals is obtained by switching between distinct parts in the controller of this single oscillator. Whereas, in the prior art, there are a temperature dependent, for the normal sensing mode, and a temperature independent, for the calibration mode, signals which are both respectively created by two distinct oscillator circuits and respectively available at the outputs of those two distinct oscillator circuits. Some interesting advantages of embodiments of the invention over prior art are globally less complexity, because of less components, and better accuracy, because of better correlation between both signals coming from same oscillator.

This object and other objects may be achieved with a temperature sensing method comprising:
- generating a temperature dependent output frequency in a sensing mode,
- generating a temperature independent output frequency in a calibration mode,
- using at least an oscillator to generate said output frequencies,
wherein both said output frequencies are alternatively generated by the same oscillator,
and wherein switching between generating a temperature dependent output frequency and generating a temperature independent output frequency is performed by changing at least a first input signal of said oscillator.

This object and other objects may be achieved with a temperature sensor comprising:
- a same oscillator adapted to alternatively generate a temperature dependent output frequency in a sensing mode and a temperature independent output frequency in a calibration mode,
- a controller of said oscillator, adapted to feed said oscillator with at least a first input signal, and adapted to change said first input signal so as to make said oscillator switch between generating a temperature dependent output frequency and generating a temperature independent output frequency.

Preferred embodiments comprise one or more of the following features:
- switching between generating a temperature dependent output frequency and generating a temperature independent output frequency is performed by changing the dependency, relatively to temperature, of said first input signal of said oscillator.
- switching from generating a temperature dependent output frequency to generating a temperature independent output frequency is performed by making dependent, relatively to temperature, said first input signal of said oscillator, so as to compensate for the dependency, relatively to temperature, of a second input signal of said oscillator, and wherein switching from generating a temperature independent output frequency to generating a temperature dependent output frequency is performed by making independent again, relatively to temperature, said first input signal of said oscillator.
- said second input signal of said oscillator remains temperature dependent, and preferably proportional to temperature, whether in the sensing mode or in the calibration mode.
- said first input signal and said second input signal are permanently compared, and wherein said switching between generating a temperature dependent output frequency and generating a temperature independent output frequency is triggered by a change in the result of said comparison.
- generating a temperature dependent output frequency in a sensing mode includes periodically generating a voltage ramp, variations of said period being representative of temperature variations to be sensed, variations of said period being preferably proportional to temperature variations to be sensed.
- the temperature sensor further comprises using a controller of said oscillator feeding said oscillator with said first input signal, and wherein changing said first input signal is performed by switching between two circuit parts of said controller.
- said switching between two circuit parts of said controller is performed by by-passing a transistor of said controller.
- a computer readable medium, having thereon a computer program comprising program instructions, the computer program being loadable into a data-processing unit and adapted to cause execution of the method according to embodiments of the invention when the computer program is run by the data-processing unit.
- the temperature sensor is adapted to perform the sensing method according to embodiments of the invention.
- said oscillator comprises a ramp generator.
- said controller comprises a temperature dependent current source disposed so that a signal proportional to said temperature dependent current is adapted to be duplicated at an input of said oscillator.
- an integrated circuit including both a temperature sensor according to embodiments of the invention and a microprocessor relatively disposed sufficiently close to each other so that said temperature sensor can measure the temperature variations of said microprocessor.
- a user equipment including at least one integrated circuit according to embodiments of the invention, preferably several integrated circuits according to embodiments of the invention, said user equipment preferably being a mobile phone.

According to a preferred embodiment of the invention, the temperature sensor is a digital temperature sensor.

According to a preferred embodiment of the invention, the temperature sensor, which is integrated within the integrated circuit also with the circuit of which the temperature is to be sensed that is preferably a microprocessor, is included in a square area of 100µm by 100µm; it covers for example an area of 70µm by 80µm.

Further features and advantages of the invention will appear from the following description of embodiments of the invention, given as non-limiting examples, with reference to the accompanying drawings listed hereunder.

### BRIEF DESCRIPTION OF THE DRAWINGS

Fig. 1 shows an example of steps of the temperature sensing method according to an embodiment of the invention.
Fig. 2 shows an example of a temperature sensor according to an embodiment of the invention.
Fig. 3 shows an example of diagram showing the ramp voltage versus time according to an embodiment of the invention.
Fig. 4A shows an example of diagrams plotting the current as a function of a number of process cases, for several values of temperature, according to an embodiment of the invention, in the sensing mode.
Fig. 4B shows an example of diagrams plotting the oscillation frequency of the ramp voltage as a function of a number of process cases, for several values of temperature, according to an embodiment of the invention, in the sensing mode.
Fig. 4C shows an example of diagrams plotting the reference voltage as a function of a number of process cases, for several values of temperature, according to an embodiment of the invention, in the sensing mode.
Fig. 5A shows an example of diagrams plotting the current as a function of a number of process cases, for several values of temperature, according to an embodiment of the invention, in the calibration mode.
Fig. 5B shows an example of diagrams plotting the oscillation frequency of the ramp voltage as a function of a number of process cases, for several values of temperature, according to an embodiment of the invention, in the calibration mode.
Fig. 5C shows an example of diagrams plotting the reference voltage as a function of a number of process cases, for several values of temperature, according to an embodiment of the invention, in the calibration mode.

### DETAILED DESCRIPTION OF THE INVENTION

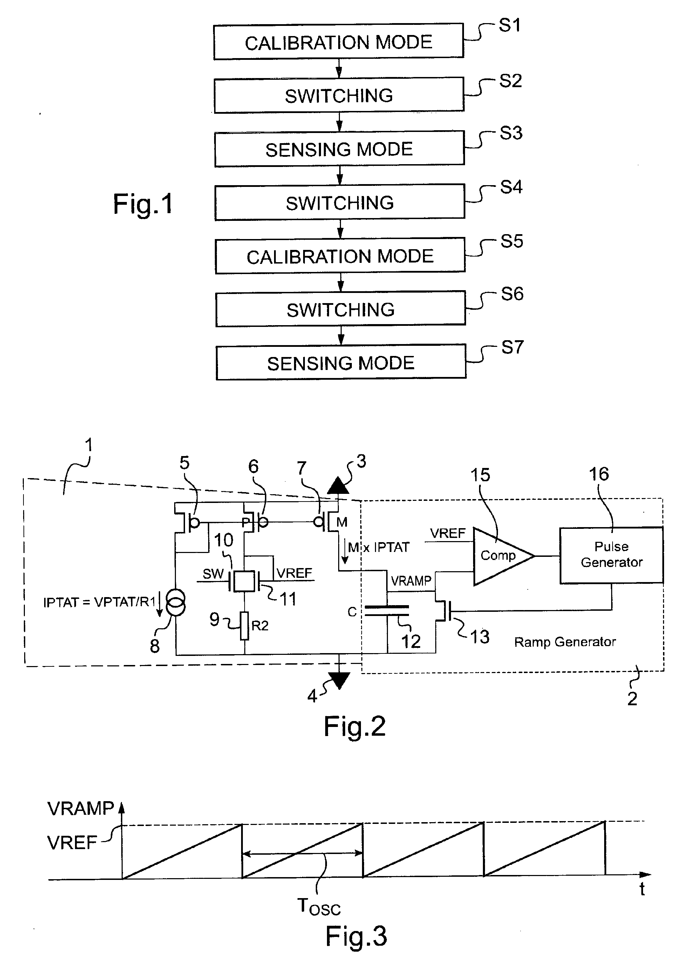

Fig. 1 shows an example of steps of the temperature sensing method according to an embodiment of the invention. The temperature sensing method comprises two different modes, a sensing mode in which the temperature of a circuit is sensed, and a calibration mode in which the temperature sensor is calibrated.

When the integrated circuit is manufactured, including a circuit which temperature is to be sensed and a temperature sensor to sense the temperature of this circuit, the temperature sensor is calibrated in situ in a calibration step S1 where the temperature sensor generates a temperature independent output frequency. Then, in a switching step S2, a switching is performed between two circuit parts of a controller of the temperature sensor.

Then, in a sensing step S3, the temperature sensor generates a temperature dependent output frequency in the sensing mode, to sense the temperature of the circuit. This sensing mode is the normal working mode of the temperature sensor. Then, in a switching step S4, a reverse switching is performed between two circuit parts of the controller of the temperature sensor.

Then, in a calibration step S5, the temperature sensor generates again a temperature independent output frequency in the calibration mode, so that the temperature sensor can be recalibrated, that is to say calibrated again, when initial calibration has been lost due to drift of components in the course of time and use. This calibration mode is a rare and exceptional mode of the temperature sensor. Then, in a switching step S6, a switching is performed between two circuit parts of a controller of the temperature sensor.

Then, in a sensing step S7, the temperature sensor generates again a temperature dependent output frequency in the sensing mode, to sense the temperature of the circuit. The temperature sensor has come back to this sensing mode which is the normal working mode of the temperature sensor.

In figure 1, in most cases, steps S1 to S3 will be used. Steps S4 to S7 may not be used; they will be used in case a second calibration or a recalibration is needed during the life course of the sensor, for example if some components present drif because of their ageing.

Fig. 2 shows an example of a temperature sensor according to an embodiment of the invention. The temperature sensor is part of an integrated circuit also including a circuit the temperature of which is to be watched. The temperature sensor comprises two main parts, a controller 1 and an oscillator which is a ramp generator 2. The temperature sensor is connected both to a voltage alimentation 3 and to the ground 4. Voltage alimentation 3 can be for example 0.85 Volts.

The controller 1 comprises a field effect transistor 5, preferably PMOS, one to P field effect transistors 6, preferably PMOS, disposed in parallel to one another, one to M field effect transistors 7, preferably PMOS, disposed in parallel to one another, a current source 8 generating a current IPTAT, a resistor 9 of a resistance value R2, a field effect transistor 10, preferably NMOS, a field effect transistor 11, preferably NMOS. Sources of all field effect transistors 5, 6 and 7, are connected to the voltage alimentation 3. Drain of field effect transistor 5 is both connected to gate of field effect transistor 5 and to current source 8 which in turn is connected to the ground 4.

In an alternative to the circuit shown on figure 2, another supplementary PMOS transistor can be added in parallel to transistor 10. The gate of this supplementary transistor would receive a signal SW_bar which would be the complementary signal to SW received by the gate of transistor 10. So when SW value is 1, SW_bar value is 0, and vice versa. That way, the resistance value of the group of transistors consisting of the transistor 10 and the supplementary transistor, would be reduced, for some value of current IPTAT and of voltage alimentation 3.

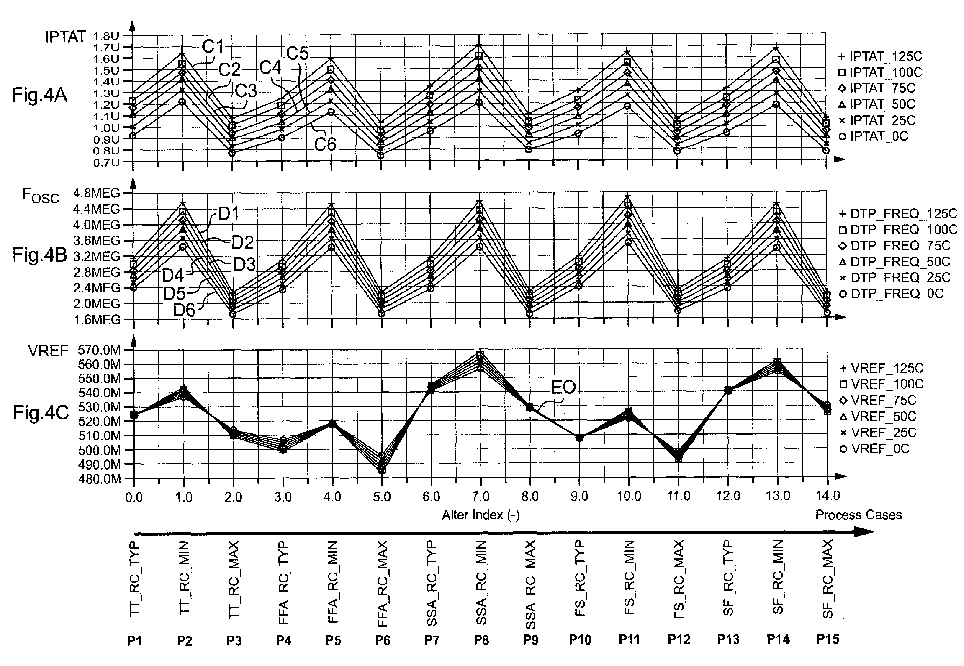

The current source 8 generates a current IPTAT = VPTAT/R1, temperature dependent current IPTAT being equal to temperature dependent voltage VPTAT divided by resistance R1. The resistor 9 of resistance value R2 is preferably made with the same material as the resistance R1. Both temperature dependent current IPTAT and temperature dependent voltage VPTAT are proportional to the absolute temperature of the circuit of which temperature is to be sensed. Several design architectures for the current source 8, generating a current proportional to the absolute temperature of the circuit to be sensed, can be found using only MOS transistor or not. Some examples with only MOS transistors are given in figure 1a of an article ["A LOW VOLTAGE CMOS CURRENT SOURCE WITH TEMPERATURE COMPENSATION" by Jing Sun; IEEE (2003), p108-111] or in figure 2 of an article ["An Ultra Low Power 1V, 220nW Temperature Sensor for Passive Wireless Applications" by Yu-Shiang Lin; IEEE (2008) Custom Integrated Circuits Conference (CICC), p. 507-510] or in figure 4 of an article ["High Linear Voltage References for on-chip CMOS Temperature Sensor" by Joseph Tzuo-sheng Tsai; IEEE (2006), P216-P219].

Gates of all field effect transistors 5, 6 and 7, are all connected together so that the current going through source and drain of field effect transistor 5 is mirrored in the current going through source and drain of all P field effect transistors 6 and of all M field effect transistors 7. Drains of the P field effect transistors 6 are connected to the drain of field effect transistor 10 and to the drain of field effect transistor 11 as well as to the gate of field effect transistor 11. The voltage on the gate of field effect transistor 11 is VREF. Sources of the field effect transistors 10 and 11 are connected to the resistor 9 which in turn is connected to the ground 4. Gate of field effect transistor 10 is connected to an external command signal SW.

The oscillator 2, which is a ramp generator 2, comprises a capacitor 12, a field effect transistor 13, preferably NMOS, a comparator 15, a pulse generator 16. Drains of the M field effect transistors 7 are connected to the capacitor 12 which in turn is connected to the ground 4, to the drain of field effect transistor 13 and to one of the inputs of the comparator 15 which then presents a voltage VRAMP which also is the voltage on the side of the capacitor 12 connected to the drains of the M field effect transistors 7. The gate of the field effect transistor 11 is connected to the other of the inputs of the comparator 15 which then presents a voltage VREF. The output of the comparator 15 is connected to the input of the pulse generator 16. The output of the pulse generator is connected to the gate of the field effect transistor 13.

Let it be assumed that for the initial conditions, VRAMP equals zero. IPTAT current coming from the drains of the M transistors 7 is used to load capacitor 12 until VRAMP reaches VREF. Then, the comparator 15 commutes. After that commutation, the pulse generator generates a pulse signal which is sent on the gate of transistor 13 to switch on transistor 13. The pulse delay time is as long as the time needed to download the capacitor 12. Following that download, transistor 13 is off again and the capacitor 12 starts again to be loaded by using the IPTAT current coming from the drains of the M transistors 7.

Switching from sensing mode to calibration mode is obtained by switching on the transistor 10 with external command signal SW. VREF signal which was temperature independent in sensing mode becomes a temperature dependent signal in calibration mode. VREF, now temperature dependent signal in calibration mode compensates for VRAMP which is always a temperature dependent signal, whether in calibration mode or in sensing mode. VREF equals VPTAT*P*(R2/R1) in calibration mode.

For this switching between transistors 11 and 10 to be fully efficient, transistor 10 should have an OFF state leakage current negligible against the current IPTAT generated by the current source 8 as well as against the IPTAT variations versus temperature. To make that, channel length of transistor 11 is preferably longer than the minimum channel length of transistor 10, at least between 4 and 20 times, for example 10 times, greater than the minimum channel length the technology. Leakage junction should also advantageously be negligible against IPTAT current generated by the current source 8 as well as against the IPTAT variations versus temperature. In sensing mode, VREF equals R2*IPTAT+V_{GS(N11)}, with V_{GS(N11)} the drop of voltage through transistor 11. VREF then equals a constant value since V_{GS(N11)} temperature variations exactly compensate for R2*IPTAT temperature variations.

VRAMP signal output frequency can be made a temperature independent signal or a temperature dependent signal simply by respectively switching off or on transistor 11. Offset voltage introduced in on state of transistor 11 could be negligible against input stage offset of the comparator 15 with IPTAT current value about 1 µA and on resistance value for transistor 11 about a few hundred of Ohm.

In a numerical example of an embodiment, the PMOS transistors 5, 6, 7 present following values : W = 20µm and L = 2.6µm. The NMOS transistor 11 presents following values : W = 13.2µm and L = 2.6µm. The NMOS transistor 10 presents following values : W = 40µm and L = 0.26µm. The NMOS transistor 13 presents following values : W = 18µm and L = 0.5µm. The minimal gate width value for this technology is 30 nm. The capacitor 12 presents a capacitance value of 0.57 pF.

It can be seen that neither additional component nor extra area is needed to generate the two different VRAMP signals, the temperature dependent and independent signals.

When VRAMP frequency is temperature independent, the oscillations period does not depend on IPTAT current, but this period is only proportional to the R2*C product, as has been seen in the calibration mode discussed above. The calibration system uses a reference clock, TCLK period, which can be used to adjust R2*C product. As the ratio R2/R1 is given to make VREF signal a temperature independent signal, R2*C product and VREF signal could be adjusted simultaneously. VRAMP calibration via R2*C product could be made even if the junction temperature is variable because VRAMP is temperature independent signal. This property is interesting when the oscillator 2 of the temperature sensor is placed close to hot spot circuits which have to run even during calibration phase or if junction temperature is not accurately known (few degrees Celsius error).

Fig. 3 shows an example of diagram showing the ramp voltage versus time according to an embodiment of the invention. In a first phase of the oscillation period Tosc, VRAMP regularly increases all the time that the capacitor 12 is loaded. Then in a second phase of the oscillation period Tosc, when VRAMP reaches VREF, the comparator 15 triggers the pulse generator 16 which makes the transistor 13 on what allows for the complete unloading of the capacitor 12. Afterwards, a next oscillation period Tosc begins.

The oscillation period Tosc of the VRAMP voltage can be written: Tosc = (VREF*R1*C) / (M*VPTAT), what gives for the oscillation frequency Fosc : Fosc = (M*VPTAT) / (VREF*R1*C). Fosc is proportional to the absolute temperature if VREF is temperature independent when transistor 13 is switched off. The oscillator 2, which is a ramp generator 2, works in the sensing mode of the temperature sensor, which is its usual and normal mode.

When, on the contrary, in the calibration mode, VREF is temperature dependent, the oscillation period Tosc of the VRAMP voltage can be written: Tosc = [(R2*P) / (R1*M)]*R1*C = (P/M)*R2*C. Tosc is proportional to the product (R2*C) and does not depend on IPTAT temperature dependent current when transistor 10 is switched on. This calibration mode can be used for (R2*C) calibration from a reference signal Tref available on the circuit. Tref is the reference temperature, for example 27°C.

A reference clock, with TCLK period, coming from a Phase Loop Lock (PLL), is used to count the number of TCLK periods which can be found in an oscillation period Tosc. The calibration can be made the following way. A few hundreds of clock periods correspond to a reference temperature of 25°C. A two few hundreds of clock periods correspond to a temperature of 125°C. With a linear variation in between for the frequency, that makes each supplementary Celsius degree correspond to a few more clock periods that can be counted within the oscillation frequency Fosc. Frequency Fosc corresponds to a period Tosc.

Simulation results of temperature dependent and temperature independent frequency circuit oscillator designed to make digital temperature sensor in C28FDSOI technology are now shown, as an illustration of the solution proposed by an embodiment of the invention.

In the horizontal direction of the plotted diagrams are to be found the process cases: there are here 15 of them, numbered from P1 to P15. These process cases correspond to the following situations, with respect to the circuit described in figure 2.

Process case P1, called TT_RC_TYP, corresponds to NMOS transistors being typical transistors, to PMOS transistors being typical transistors, to resistances having typical values within a dispersion range, to capacitor having a typical value within a dispersion range. Process case P2, called TT_RC_MIN, corresponds to NMOS transistors being typical transistors, to PMOS transistors being typical transistors, to resistances having minimal values within a dispersion range, to capacitor having a minimal value within a dispersion range. Process case P3, called TT_RC_MAX, corresponds to NMOS transistors being typical transistors, to PMOS transistors being typical transistors, to resistances having maximal values within a dispersion range, to capacitor having a maximal value within a dispersion range.

Process case P4, called FFA_RC_TYP, corresponds to NMOS transistors being fast transistors, to PMOS transistors being fast analogical transistors, to resistances having typical values within a dispersion range, to capacitor having a typical value within a dispersion range. Process case P5, called FFA_RC_MIN, corresponds to NMOS transistors being fast transistors, to PMOS transistors being fast analogical transistors, to resistances having minimal values within a dispersion range, to capacitor having a minimal value within a dispersion range. Process case P6, called FFA_RC_MAX, corresponds to NMOS transistors being fast transistors, to PMOS transistors being fast analogical transistors, to resistances having maximal values within a dispersion range, to capacitor having a maximal value within a dispersion range.

Process case P7, called SSA_RC_TYP, corresponds to NMOS transistors being slow transistors, to PMOS transistors being slow analogical transistors, to resistances having typical values within a dispersion range, to capacitor having a typical value within a dispersion range. Process case P8, called SSA_RC_MIN, corresponds to NMOS transistors being slow transistors, to PMOS transistors being slow analogical transistors, to resistances having minimal values within a dispersion range, to capacitor having a minimal value within a dispersion range. Process case P9, called SSA_RC_MAX, corresponds to NMOS transistors being slow transistors, to PMOS transistors being slow analogical transistors, to resistances having maximal values within a dispersion range, to capacitor having a maximal value within a dispersion range.

Process case P10, called FS_RC_TYP, corresponds to NMOS transistors being fast transistors, to PMOS transistors being slow transistors, to resistances having typical values within a dispersion range, to capacitor having a typical value within a dispersion range. Process case P11, called FS_RC_MIN, corresponds to NMOS transistors being fast transistors, to PMOS transistors being slow transistors, to resistances having minimal values within a dispersion range, to capacitor having a minimal value within a dispersion range. Process case P12, called FS_RC_MAX, corresponds to NMOS transistors being fast transistors, to PMOS transistors being slow transistors, to resistances having maximal values within a dispersion range, to capacitor having a maximal value within a dispersion range.

Process case P13, called SF_RC_TYP, corresponds to NMOS transistors being slow transistors, to PMOS transistors being fast transistors, to resistances having typical values within a dispersion range, to capacitor having a typical value within a dispersion range. Process case P14, called SF_RC_MIN, corresponds to NMOS transistors being slow transistors, to PMOS transistors being fast transistors, to resistances having minimal values within a dispersion range, to capacitor having a minimal value within a dispersion range. Process case P15, called SF_RC_MAX, corresponds to NMOS transistors being slow transistors, to PMOS transistors being fast transistors, to resistances having maximal values within a dispersion range, to capacitor having a maximal value within a dispersion range.

In the vertical direction of the plotted diagrams are to be found a family of curves corresponding respectively to the following set of temperatures, 125°C, 100°C, 75°C, 50°C, 25°C, 0°C, and corresponding to plotting parameters. Depending on the parameter which is plotted, either all the curves of the family are distinct from one another, meaning that the parameter is temperature dependent, or all the curves are all mixed into one and a single curve, meaning that the parameter is temperature independent.

Fig. 4A shows an example of diagrams plotting the current as a function of a number of process cases, for several values of temperature, according to an embodiment of the invention, in the sensing mode. The current IPTAT is plotted as a function of the process cases P1 to P15 for the family of temperatures ranging from 125°C to 0°C. It gives the curves C1 to C6 which are all distinct from one another. Hence, it can be deduced that current IPTAT is temperature dependent.

Fig. 4B shows an example of diagrams plotting the oscillation frequency of the ramp voltage as a function of a number of process cases, for several values of temperature, according to an embodiment of the invention, in the sensing mode. The oscillation frequency Fosc is plotted as a function of the process cases P1 to P15 for the family of temperatures ranging from 125°C to 0°C. It gives the curves D1 to D6 which are all distinct from one another. Hence, it can be deduced that oscillation frequency Fosc is temperature dependent. In this sensing mode, it is this parameter of oscillation frequency Fosc which is used as the parameter representative of, and preferably proportional to, the temperature to be sensed.

Fig. 4C shows an example of diagrams plotting the reference voltage as a function of a number of process cases, for several values of temperature, according to an embodiment of the invention, in the sensing mode. The reference voltage VREF is plotted as a function of the process cases P1 to P15 for the family of temperatures ranging from 125°C to 0°C. The transistor 11 is on whereas the transistor 10 is off. It gives only one curve E0, because all curves of the family are mixed into this same curve E0. Hence, it can be deduced that reference voltage VREF is temperature independent.

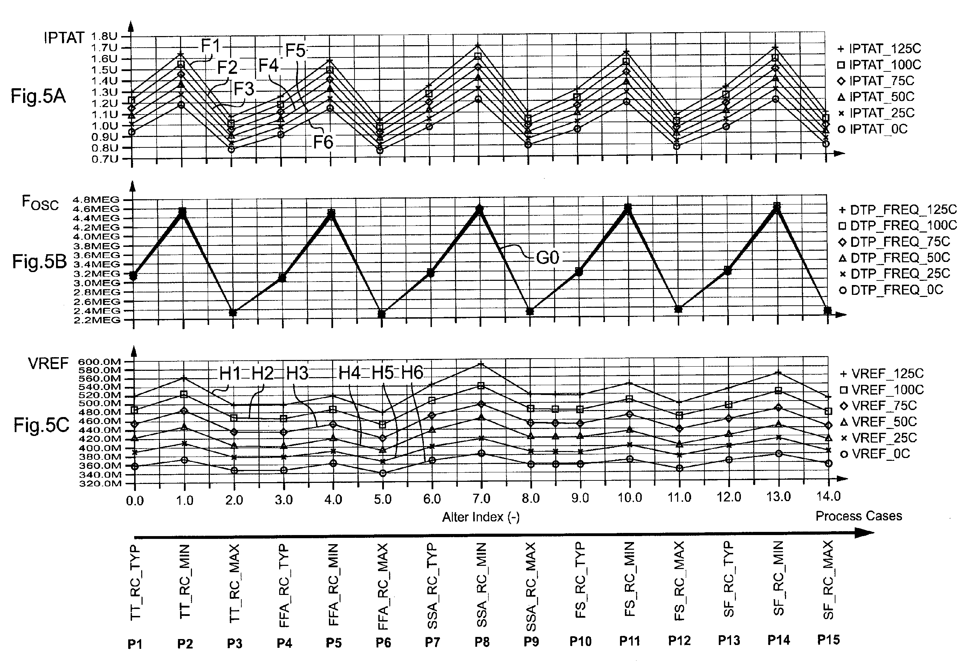

Fig. 5A shows an example of diagrams plotting the current as a function of a number of process cases, for several values of temperature, according to an embodiment of the invention, in the calibration mode. The current IPTAT is plotted as a function of the process cases P1 to P15 for the family of temperatures ranging from 125°C to 0°C. It gives the curves F1 to F6 which are all distinct from one another. Hence, it can be deduced that current IPTAT is temperature dependent.

Fig. 5B shows an example of diagrams plotting the oscillation frequency of the ramp voltage as a function of a number of process cases, for several values of temperature, according to an embodiment of the invention, in the calibration mode. The oscillation frequency Fosc is plotted as a function of the process cases P1 to P15 for the family of temperatures ranging from 125°C to 0°C. It gives only one curve G0, because all curves of the family are mixed into this same curve G0. Hence, it can be deduced that oscillation frequency Fosc is temperature independent. In this calibration mode, it is this parameter of oscillation frequency Fosc which is used to perform the calibration of the temperature sensor so as to be more accurate later on, in the sensing mode.

Fig. 5C shows an example of diagrams plotting the reference voltage as a function of a number of process cases, for several values of temperature, according to an embodiment of the invention, in the calibration mode. The reference voltage VREF is plotted as a function of the process cases P1 to P15 for the family of temperatures ranging from 125°C to 0°C. The transistor 10 is on whereas the transistor 11 is off. It gives the curves H1 to H6 which are all distinct from one another. Hence, it can be deduced that reference voltage VREF is temperature dependent.

## Claims

1. Temperature sensing method comprising:
- generating a temperature dependent output frequency in a sensing mode (S3, S7),
- generating a temperature independent output frequency in a calibration mode (S1, S5),
- using at least an oscillator (2) to generate said output frequencies,
wherein both said output frequencies are alternatively generated by the same oscillator (2),
and wherein switching (S2, S4, S6) between generating a temperature dependent output frequency and generating a temperature independent output frequency is performed by changing at least a first input signal (VREF) of said oscillator (2).

2. Temperature sensing method according to claim 1, wherein switching (S2, S4, S6) between generating a temperature dependent output frequency and generating a temperature independent output frequency is performed by changing the dependency, relatively to temperature, of said first input signal (VREF) of said oscillator (2).

3. Temperature sensing method according to claim 2, wherein switching (S2, S4, S6) from generating a temperature dependent output frequency to generating a temperature independent output frequency is performed by making dependent, relatively to temperature, said first input signal (VREF) of said oscillator (2), so as to compensate for the dependency, relatively to temperature, of a second input signal (VRAMP) of said oscillator (2), and wherein switching (S2, S4, S6) from generating a temperature independent output frequency to generating a temperature dependent output frequency is performed by making independent again, relatively to temperature, said first input signal (VREF) of said oscillator (2).

4. Temperature sensing method according to claim 3, wherein said second input signal (VRAMP) of said oscillator (2) remains temperature dependent, and preferably proportional to temperature, whether in the sensing mode (S3, S7) or in the calibration mode (S1, S5).

5. Temperature sensing method according to any of claims 3 to 4, wherein said first input signal (VREF) and said second input signal (VRAMP) are permanently compared, and wherein said switching (S2, S4, S6) between generating a temperature dependent output frequency and generating a temperature independent output frequency is triggered by a change in the result of said comparison.

6. Temperature sensing method according to any of preceding claims, wherein generating a temperature dependent output frequency in a sensing mode (S3, S7) includes periodically generating a voltage ramp, variations of said period being representative of temperature variations to be sensed, variations of said period being preferably proportional to temperature variations to be sensed.

7. Temperature sensing method according to any of preceding claims, wherein it further comprises using a controller (1) of said oscillator (2) feeding said oscillator (2) with said first input signal (VREF), and wherein changing said first input signal (VREF) is performed by switching between two circuit parts (10, 11) of said controller (1).

8. Temperature sensing method according to claim 7, wherein said switching between two circuit parts (10, 11) of said controller (1) is performed by by-passing a transistor (11) of said controller (1).

9. A computer readable medium, having a computer program comprising program instructions, the computer program being loadable into a data-processing unit and adapted to cause execution of the method according to any of preceding claims when the computer program is run by the data-processing unit.

10. Temperature sensor comprising:
- a same oscillator (2) adapted to alternatively generate a temperature dependent output frequency in a sensing mode and a temperature independent output frequency in a calibration mode,
- a controller (1) of said oscillator (2), adapted to feed said oscillator (2) with at least a first input signal (VREF), and adapted to change said first input signal (VREF) so as to make said oscillator (2) switch between generating a temperature dependent output frequency and generating a temperature independent output frequency.

11. Temperature sensor according to claim 10, wherein said oscillator comprises a ramp generator (2).

12. Temperature sensor according to claim 10, wherein said controller (1) comprises a temperature dependent current source (8) disposed so that a signal proportional (M*IPTAT) to said temperature dependent current (IPTAT) is adapted to be duplicated at an input of said oscillator (2).

13. Integrated circuit including both a temperature sensor according to any of claims 10 to 12 and a microprocessor relatively disposed sufficiently close to each other so that said temperature sensor can measure the temperature variations of said microprocessor.

14. User equipment including at least one integrated circuit according to claim 13, preferably several integrated circuits according to claim 13, said user equipment preferably being a mobile phone.

## Patentansprüche

1. Temperaturerfassungsverfahren, umfassend:
- Erzeugen einer temperaturabhängigen Ausgabefrequenz in einem Erfassungsmodus (S3, S7),
- Erzeugen einer temperaturunabhängigen Ausgabefrequenz in einem Kalibriermodus (S1, S5).
- Verwenden von mindestens einem Oszillator (2) zum Erzeugen der Ausgabefrequenzen,
wobei beide Ausgabefrequenzen vom selben Oszillator (2) abwechselnd erzeugt werden,
und wobei das Umschalten (S2, S4, S6) zwischen dem Erzeugen einer temperaturabhängigen Ausgabefrequenz und dem Erzeugen einer temperaturunabhängigen Ausgabefrequenz durch Ändern von mindestens einem ersten Eingabesignal (VREF) des Oszillators (2) ausgeführt wird.

2. Temperaturerfassungsverfahren nach Anspruch 1, wobei das Umschalten (S2, S4, S6) zwischen dem Erzeugen einer temperaturabhängigen Ausgabefrequenz und dem Erzeugen einer temperaturunabhängigen Ausgabefrequenz durch Ändern der Abhängigkeit, relativ zur Temperatur, des ersten Eingabesignals (VREF) des Oszillators (2) ausgeführt wird.

3. Temperaturerfassungsverfahren nach Anspruch 2, wobei das Umschalten (S2, S4, S6) vom Erzeugen einer temperaturabhängigen Ausgabefrequenz zum Erzeugen einer temperaturunabhängigen Ausgabefrequenz dadurch ausgeführt wird, dass das erste Eingabesignal (VREF) des Oszillators (2) von der Temperatur abhängig gemacht wird, um so die Abhängigkeit eines zweiten Eingabesignals (VRAMP) des Oszillators (2) relativ von der Temperatur zu kompensieren, und wobei das Umschalten (S2, S4, S6) vom Erzeugen einer temperaturunabhängigen Ausgabefrequenz zum Erzeugen einer temperaturabhängigen Ausgabefrequenz wieder dadurch erfolgt, dass das erste Eingabesignal (VREF) des Oszillators (2) unabhängig von der Temperatur gemacht wird.

4. Temperaturerfassungsverfahren nach Anspruch 3, wobei das zweite Eingabesignal (VRAMP) des Oszillators (2) temperaturabhängig bleibt und vorzugsweise proportional zur Temperatur ist, sei es im Erfassungsmodus (S3, S7) oder im Kalibriermodus (S1, S5).

5. Temperaturerfassungsverfahren nach einem der Ansprüche 3 bis 4, wobei das erste Eingangssignal (VREF) und das zweite Eingangssignal (VRAMP) ständig verglichen werden und wobei das Umschalten (S2, S4, S6) zwischen dem Erzeugen einer temperaturunabhängigen Ausgabefrequenz und dem Erzeugen einer temperaturunabhängigen Ausgabefrequenz durch eine Änderung im Ergebnis des Vergleichs ausgelöst wird.

6. Temperaturerfassungsverfahren nach einem der vorherigen Ansprüche, wobei das Erzeugen einer temperaturabhängigen Ausgabefrequenz in einem Erfassungsmodus (S3, S7) das periodische Erzeugen einer Spannungsrampe umfasst, wobei Variationen der Periode repräsentativ für Temperaturvariationen sind, die erfasst werden sollen, wobei Variationen der Periode vorzugsweise proportional zu Temperaturvariationen sind, die erfasst werden sollen.

7. Temperaturerfassungsverfahren nach einem der vorherigen Ansprüche, wobei es ferner das Verwenden eines Reglers (1) des Oszillators (2) umfasst, der den Oszillator (2) mit dem ersten Eingangssignal (VREF) versorgt, und wobei das Ändern des ersten Eingangssignals (VREF) durch Umschalten zwischen zwei Schaltungsteilen (10, 11) des Reglers (1) ausgeführt wird.

8. Temperaturerfassungsverfahren nach Anspruch 7, wobei das Umschalten zwischen zwei Schaltungsteilen (10, 11) des Reglers (1) durch Umgehen eines Transistors (11) des Reglers (1) ausgeführt wird.

9. Computerlesbares Medium, das ein Computerprogramm hat, welches Programmanweisungen umfasst, wobei das Computerprogramm in eine datenverarbeitende Einheit geladen werden kann und dafür ausgelegt ist, das Ausführen des Verfahrens nach den vorhergehenden Ansprüchen zu bewirken, wenn das Computerprogramm von der datenverarbeitenden Einheit ausgeführt wird.

10. Temperatursensor, umfassend:
- einen gleichen Oszillator (2), der zum abwechselnden Erzeugen einer temperaturabhängigen Ausgabefrequenz in einem Erfassungsmodus und einer temperaturunabhängigen Ausgabefrequenz in einem Kalibriermodus ausgelegt ist,
- einen Regler (1) des Oszillators (2), der zum Versorgen des Oszillators (2) mit mindestens einem ersten Eingangssignal (VREF) und zum Ändern des ersten Eingangssignals (VREF) ausgelegt ist, um so den Oszillator (2) zum Umschalten zwischen dem Erzeugen einer temperaturabhängigen Ausgabefrequenz und dem Erzeugen einer temperaturabhängigen Ausgabefrequenz zu veranlassen.

11. Temperatursensor nach Anspruch 10, wobei der Oszillator einen Rampengenerator (2) umfasst.

12. Temperatursensor nach Anspruch 10, wobei der Regler (1) eine temperaturabhängige Stromquelle (8) umfasst, die so angeordnet ist, dass ein Signal proportional (M*IPTAT) zum temperaturabhängigen Strom (IPTAT) dafür ausgelegt ist, an einem Eingang des Oszillators (2) dupliziert zu werden.

13. Integrierte Schaltung, die sowohl einen Temperatursensor nach einem der Ansprüche 10 bis 12 als auch einen Mikroprozessor umfasst, die ausreichend nahe beieinander angeordnet sind, so dass der Temperatursensor die Temperaturveränderungen des Mikroprozessors messen kann.

14. Nutzerausrüstung, einschließlich mindestens einer integrierten Schaltung nach Anspruch 13, vorzugsweise mehrere integrierte Schaltungen nach Anspruch 13, wobei die Nutzerausrüstung vorzugsweise ein Mobiltelefon ist.

## Revendications

1. Procédé de captage de la température comprenant les étapes consistant à :
- générer une fréquence de sortie dépendante de la température dans un mode de captage (S3, S7),
- générer une fréquence de sortie indépendante de la température dans un mode d'étalonnage (S1, S5),
- utiliser au moins un oscillateur (2) afin de générer lesdites fréquences de sortie,
dans lequel les deux dites fréquences de sortie sont générées alternativement par le même oscillateur (2),
et dans lequel la commutation (S2, S4, S6) entre la génération d'une fréquence de sortie dépendante de la température et la génération d'une fréquence de sortie indépendante de la température est réalisée en changeant au moins un premier signal d'entrée (VREF) dudit oscillateur (2).

2. Procédé de captage de la température selon la revendication 1, dans lequel la commutation (S2, S4, S6) entre la génération d'une fréquence de sortie dépendante de la température et la génération d'une fréquence de sortie indépendante de la température est effectuée en changeant la dépendance, par rapport à la température, dudit premier signal d'entrée (VREF) dudit oscillateur (2).

3. Procédé de captage de la température selon la revendication 2, dans lequel la commutation (S2, S4, S6) entre la génération d'une fréquence de sortie dépendante de la température et la génération d'une fréquence de sortie indépendante de la température est réalisée en rendant dépendant, relativement à la température, ledit premier signal d'entrée (VREF) dudit oscillateur (2), de manière à compenser la dépendance, par rapport à la température, d'un deuxième signal d'entrée (VRAMP) dudit oscillateur (2), et dans lequel la commutation (S2, S4, S6) entre la génération d'une fréquence de sortie indépendante de la température et la génération d'une fréquence de sortie dépendante de la température est réalisée en rendant de nouveau indépendant, relativement à la température, ledit premier signal d'entrée (VREF) dudit oscillateur (2).

4. Procédé de captage de la température selon la revendication 3, dans lequel ledit deuxième signal d'entrée (VRAMP) dudit oscillateur (2) reste dépendant de la température, et de préférence proportionnel à la température, que ce soit dans le mode de captage (S3, S7) ou dans le mode d'étalonnage (S1, S5).

5. Procédé de captage de la température selon l'une quelconque des revendications 3 à 4, dans lequel ledit premier signal d'entrée (VREF) et ledit deuxième signal d'entrée (VRAMP) sont comparés en permanence, et dans lequel ladite commutation (S2, S4, S6) entre la génération d'une fréquence de sortie dépendante de la température et la génération d'une fréquence de sortie indépendante de la température est déclenchée par une variation du résultat de ladite comparaison.

6. Procédé de captage de la température selon l'une quelconque des revendications précédentes, dans lequel la génération d'une fréquence de sortie dépendante de la température dans un mode de captage (S3, S7) comprend la génération périodique d'une rampe de tension, des variations de ladite période étant représentatives des variations de température à capter, des variations de ladite période étant de préférence proportionnelles aux variations de température à capter.

7. Procédé de captage de la température selon l'une quelconque des revendications précédentes, dans lequel il comprend en outre l'utilisation d'un contrôleur (1) de l'oscillateur (2) et qui alimente ledit oscillateur (2) avec ledit premier signal d'entrée (VREF), et dans lequel le changement dudit premier signal d'entrée (VREF) est effectué par commutation entre deux parties de circuit (10, 11) dudit contrôleur (1).

8. Procédé de captage de la température selon la revendication 7, dans lequel ladite commutation entre les deux parties de circuit (10, 11) dudit contrôleur (1) est effectuée par dérivation d'un transistor (11) dudit contrôleur (1).

9. Produit de programme informatique comprenant un support lisible par ordinateur, portant un programme d'ordinateur comprenant des instructions de programme, le programme d'ordinateur pouvant être chargé dans une unité de traitement de données et adapté pour provoquer l'exécution du procédé selon l'une quelconque des revendications précédentes lorsque le programme d'ordinateur est exécuté par l'unité de traitement de données.

10. Capteur de température comprenant:
- un même oscillateur (2) apte à générer alternativement une fréquence de sortie dépendante de la température dans un mode de captage et une fréquence de sortie indépendante de la température dans un mode d'étalonnage,
- un contrôleur (1) dudit oscillateur (2), adapté pour alimenter ledit oscillateur (2) avec au moins un premier signal d'entrée (VREF), et adapté pour modifier ledit premier signal d'entrée (VREF) de sorte que ledit oscillateur (2) provoque une commutation entre la génération d'une fréquence de sortie dépendante de la température et la génération d'une fréquence de sortie indépendante de la température.

11. Capteur de température selon la revendication 10, dans lequel ledit oscillateur comprend un générateur de rampe (2).

12. Capteur de température selon la revendication 10, dans lequel ledit contrôleur (1) comprend une source de courant dépendante de la température (8) disposée de telle sorte qu'un signal proportionnel (M*IPTAT) audit courant dépendant de la température (IPTAT) est adapté pour être dupliqué à une entrée dudit oscillateur (2).

13. Circuit intégré comprenant à la fois un capteur de température selon l'une quelconque des revendications 10 à 12 et un microprocesseur disposés, relativement, suffisamment près l'un de l'autre de sorte que ledit capteur de température permet de mesurer les variations de température dudit microprocesseur.

14. Equipement d'utilisateur comprenant au moins un circuit intégré selon la revendication 13, de préférence plusieurs circuits intégrés selon la revendication 13, ledit équipement d'utilisateur étant de préférence un téléphone mobile.
